# EUROPÄISCHE PATENTSCHRIFT

(11) **EP 0 623 992 B1**
(45) Veröffentlichungstag und Bekanntmachung des Hinweises auf die Patenterteilung: **05.07.2000**
(21) Anmeldenummer: 94201172.7
(22) Anmeldetag: 28.04.1994
(51) Int. Cl.: H03B 5/12

(54) **Oszillator**
Oscillator
Oscillateur

(30) Priorität: 03.05.1993 DE 4314424
(43) Veröffentlichungstag der Anmeldung: 09.11.1994
(73) Patentinhaber: Philips Corporate Intellectual Property GmbH, 52064 Aachen (DE); Koninklijke Philips Electronics N.V., 5621 BA Eindhoven (NL)
(72) Erfinder: Brilka, Joachim, c/o Philips Patentverwaltung GmbH, D-20097 Hamburg (DE); Weltersbach, Joachim, c/o Philips Patentverwaltung, D-20097 Hamburg (DE)
(74) Vertreter: Peters, Carl Heinrich, Dipl.-Ing.

(56) Entgegenhaltungen:
- EP-A- 0 292 077
- WO-A-82/03509
- DE-A- 3 313 868
- GB-A- 2 215 929

## Beschreibung

Die Erfindung bezieht sich auf einen Oszillator mit für eine erste Schwingfrequenz vorgesehenen ersten frequenzbestimmenden Elementen.

Für die Mischung und Demodulation von Videosignalen werden Oszillatoren zum Erzeugen von Schwingungen mit verschiedenen Frequenzen benötigt. Soll nur ein Videosignal einer bestimmten Übertragungsnorm verarbeitet werden, können dafür Oszillatoren mit festen Schwingfrequenzen Verwendung finden. Soll jedoch eine Schaltungsanordnung für die Verarbeitung von Videosignalen unterschiedlicher Übertragungsnormen gleichermaßen geeignet sein, würde dies für die Verarbeitung von Signalen der dabei auftretenden, unterschiedlichen Frequenzen eine große Anzahl verschiedener Oszillatoren erfordern. Ein derartiger Schaltungsaufbau ist jedoch sehr aufwendig und daher einerseits unwirtschaftlich als auch andererseits schwierig in der Herstellung und dem Abgleich.

Der Erfindung liegt daher die Aufgabe zugrunde, einen Oszillator insbesondere für die Verwendung bei der Videosignalverarbeitung zu schaffen, der auf wenigstens zwei Schwingfrequenzen umschaltbar und abstimmbar ist.

Ein Oszillator der den Oberbegriff des Anspruchs 1 bildet ist beispielsweise aus DE-A-3313868 bekannt.

Diese Aufgabe wird bei einem Oszillator der eingangs genannten Art gelöst durch wenigstens ein zweites frequenzbestimmendes Element, welches zum Einstellen des Oszillators auf eine zweite Schwingfrequenz den ersten frequenzbestimmenden Elementen zuschaltbar ist gekennzeichnet durch ein Verstärkungselement, dessen Verstärkungsfaktor gemeinsam mit dem Zuschalten wenigstens eines der zweiten frequenzbestimmenden Elemente umschalterbar ist, und über das den ersten frequenzbestimmenden Elementen ein Abgleichsignal zuführbar ist.

Durch die Erfindung wird nicht nur der Bauteileaufwand gegegenüber zwei getrennt aufgebauten Oszillatoren stark verringert, sondern es werden auch die Voraussetzungen dafür geschaffen, daß beispielsweise eine Mehrzahl von Videosignalen nach unterschiedlichen Übertragungsnormen mit einer einzigen, nach Bedarf umschaltbaren bzw. einstellbaren Signalverarbeitungsanordnung übertragen, verarbeitet und umgesetzt werden können. Dadurch werden möglichst viele Bauteile der Gesamtanordnung für möglichst viele verschiedene Einsatzzwecke herangezogen und somit insgesamt ein vereinfachter Aufbau erreicht. Außerdem sind dadurch ohne weiteres Zutun wenigstens annähernd gleiche Übertragungsbedingungen für alle zu verarbeitenden Videosignale geschaffen. Insbesondere eignet sich der erfindungsgemäße Oszillator auch als umschaltbarer, spannungsgesteuerter Oszillator zum Einsatz in Phasenregelschleifen, die wahlweise auf die insbesondere französischen Übertragungsnormen Secam L einerseits und Secam L'(VHF Band I) einstellbar sind. Mit einem solchen, umschaltbaren Oszillator kann in einfacher Weise eine umschaltbare Zwischenfrequenzschwingung erzeugt werden, beispielsweise für die "L-Norm" eine Bildträgerschwingung von 38,9 MHz und für die "L'-Norm" eine Bildträgerschwingung von 33,9 MHz. Der erfindungsgemäß umschaltbare Oszillator hat dabei den Vorteil, daß einerseits ein schmaler Fangbereich für eine mit diesem Oszillator aufgebaute Phasenregelschleife eingestellt werden kann, um ein Einfangen auf einem Nachbarkanal oder einer Tonträgerschwingung zu vermeiden, andererseits die Phasenregelschleife jedoch in einem weiteren Frequenzbereich einsetzbar ist.

Vorzugsweise umfaßt nach einer Fortbildung der Erfindung das erste frequenzbestimmende Element eine erste Kapazität, der eine zweite Kapazität als das zweite frequenzbestimmende Element parallel schaltbar ist. Eine derartige Anordnung kann mit einfachen konstruktiven Mitteln verwirklicht werden.

Das bzw. die zweite(n) frequenzbestimmende(n) Element(e) ist bzw. sind vorteilhaft über wenigstens eine Schaltdiode zuschaltbar. Eine derartige Schaltdiode ist einfach aufgebaut und auch für hohe Schwingfrequenzen einsetzbar. Sie kann mit einfachen Mitteln, vorzugsweise durch einen Gleichstrom, zwischen einem leitenden und einem gesperrten Zustand umgeschaltet werden und ist vorzugsweise auch zusammen mit den Bauteilen des Oszillators auf einem Halbleiterkörper integrierbar.

In einer Weiterbildung des erfindungsgemäßen Oszillators ist eine Speiseschaltung vorgesehen, die wenigstens eine steuerbare Stromquelle umfaßt, durch die die Schaltdiode gespeist wird und wahlweise in den leitenden oder gesperrten Zustand schaltbar ist. Auch eine derartige Speiseschaltung kann einfach und kompakt mit den Elementen des Oszillators und der Schaltdiode zusammengefaßt werden. Dabei kann bzw. können die steuerbare(n) Stromquelle(n) bevorzugt durch eine (erste) Treiberstufe gesteuert werden, die von der Speiseschaltung umfaßt ist. Vorteilhaft enthält diese (erste) Treiberstufe einen Schalttransistor, durch den die steuerbare(n) Stromquelle(n) zwischen zwei vorbestimmten Stromwerten umgeschaltet werden kann bzw. können. Dadurch ist das zweite frequenzbestimmende Element in einfacher und zuverlässiger Weise auch über eine Logikschaltung mit sogenannten logischen Signalpegeln zu- bzw. abschaltbar.

Vorteilhaft umfaßt die Speiseschaltung der vorgenannten Art auch eine Einrichtung zum Abstimmen des zweiten frequenzbestimmenden Elements. Damit wird durch die Speiseschaltung nicht nur das zweite frequenzbestimmende Element wahlweise zugeschaltet, sondern auch auf die korrekte Schwingfrequenz des Oszillators abgestimmt. Für einen einfachen und betriebssicheren Aufbau weist in einer Weiterbildung des erfindungsgemäßen Oszillators das zweite frequenzbestimmende Element wenigstens eine Kapazitätsdiode auf und umfaßt die Einrichtung zum Abstimmen des zweiten frequenzbestimmenden Elements eine zweite Treiberstufe zum Erzeugen einer Einstellspannung für diese Kapazitätsdiode.

Vorteilhaft umfassen die vorstehend genannten, in der Speiseschaltung enthaltenen Treiberstufen je einen Differenzverstärker. Beide Differenzverstärker sind dabei an je einem ihrer Eingänge mit einem gemeinsamen Steuersignal gesteuert. Den zweiten Eingängen der Differenzverstärker werden Schwellenwerte unterschiedlicher Höhe zugeführt, die vorzugsweise als Referenzspannungen von einem gemeinsamen Widerstandsspannungsteiler oder einer entsprechenden Referenzspannungsquelle abgeleitet werden. Diese Schwellenwerte sind derart bemessen, daß der der ersten Treiberstufe zugeführte Schwellenwert einen durch den der zweiten Treiberstufe zugeführten Schwellenwert festgelegten Aussteuerungsbereich der zweiten Treiberstufe begrenzt. Auf diese Weise ist es möglich, mit dem gemeinsamen Steuersignal nicht nur das zweite frequenzbestimmende Element wahlweise zu- oder abzuschalten, sondern seinen Wert in einem vorgegebenen Bereich abzustimmen. Durch die Wahl der Schwellenwerte wird dieser Abstimmbereich wunschgemäß präzise festgelegt.

Weitere Ausgestaltungen der Erfindung ergeben sich aus den Unteransprüchen.

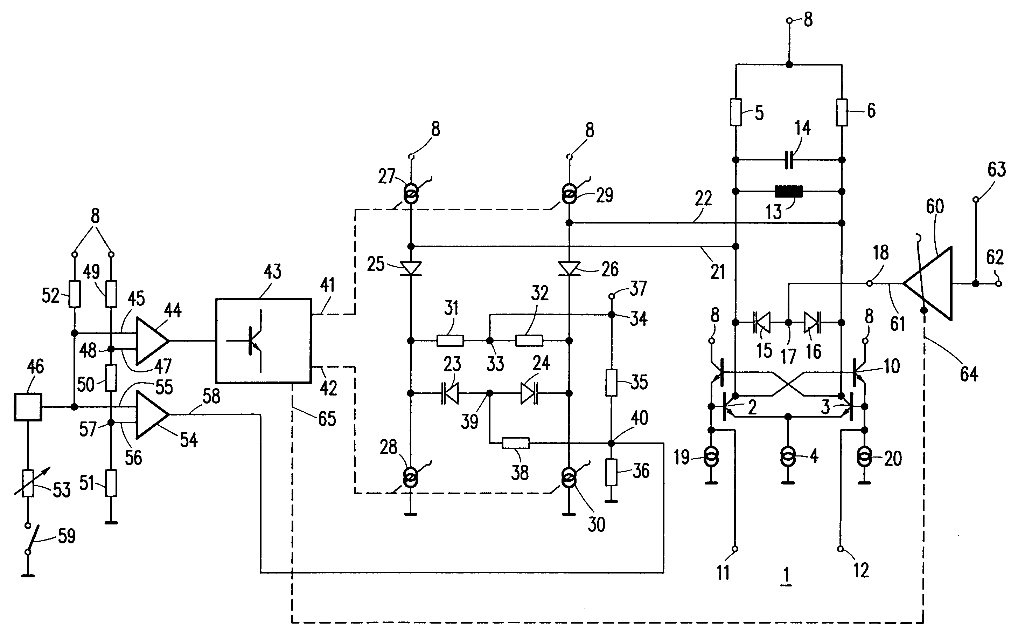

Ein Ausführungsbeispiel der Erfindung ist in der Zeichnung dargestellt und wird im nachfolgenden näher beschrieben. Ein Oszillator 1 umfaßt eine Differenzverstärkerstufe aus zwei Transistoren 2, 3, die mit ihren Emitteranschlüssen gemeinsam über eine Stromquelle 4 mit Masse verbunden sind. Die Kollektoranschlüsse der Transistoren 2, 3 sind über je einen Kollektorwiderstand 5, 6 mit einem Versorgungsspannungsanschluß 8 verbunden. Jeder der Kollektoranschlüsse der Transistoren 2 bzw. 3 ist mit dem Basisanschluß eines Emitterfolgertransistors 9 bzw. 10 verbunden, deren Kollektoranschlüsse am Versorgungsspannungsanschluß 8 liegen und deren Emitteranschlüsse mit Ausgangsanschlüssen 11, 12 verbunden sind. Von jedem der Emitterfolgertransistoren 9 bzw. 10 ist über dessen Emitteranschluß eine Verbindung an den Basisanschluß eines der Transistoren 2, 3 der Differenzverstärkerstufe hergestellt in der Weise, daS über jeden der Emitterfolgertransistoren 9 bzw. 10 der Kollektoranschluß eines der Transistoren 2 bzw. 3 mit dem Basisanschluß des jeweils anderen Transistors 3 bzw. 2 der Differenzverstärkerstufe gekoppelt ist. Auf diese Weise wird eine Mitkopplung erzielt. Die für eine erste Schwingfrequenz maßgeblichen ersten frequenzbestimmenden Elemente sind zwischen den Kollektoranschlüssen der Transistoren 2, 3 der Differenzverstärkerstufe angeschlossen und umfassen eine Induktivität 13, eine Kapazität 14 sowie als abstimmbares Element die gegensinnige Reihenschaltung zweier Kapazitätsdioden 15, 16, deren Verbindungspunkt 17 an einen Referenzspannungsanschluß 18 geführt ist, über den den Kapazitätsdioden 15, 16 eine Sperrvorspannung aufgeprägt werden kann. Damit ist über den Referenzspannungsanschluß 18 ein Abgleich des Oszillators 1 auf die erste Schwingfrequenz möglich.

Zur Speisung der Emitterfolgertransistoren 9, 10 sind deren Emitteranschlüsse mit Stromquellen 19 bzw. 20 verbunden, die gegen Masse geschaltet sind.

Über den Referenzspannungsanschluß 18 kann der Oszillator 1 auch als spannungsgesteuerter Oszillator betrieben werden, z.B. beim Einsatz in einer phasenverriegelten Regelschleife.

Zum Umschalten des Oszillators 1 auf eine zweite Schwingfrequenz ist dem ersten frequenzbestimmenden Element 13 bis 16 über Verbindungen 21, 22 ein zweites frequenzbestimmendes Element parallel geschaltet, welches aus zwei gegensinnig in Reihe geschalteten Kapazitätsdioden 23, 24 besteht. Das zweite frequenzbestimmende Element 23, 24 ist über je eine Schaltdiode 25, 26 an die Verbindungen 21 bzw. 22 angeschlossen. In Reihe mit jeder der Schaltdioden 25, 26 sind je zwei steuerbare Stromquellen 27, 28 bzw. 29, 30 zwischen den Versorgungsspannungsanschluß 8 und Masse geschaltet. Dies ist in der Weise vorgenommen, daß je eine der Stromquellen mit je einem ihrer Anschlüsse an einen der Verbindungspunkte zwischen der Verbindung 21 und der ersten Schaltdiode 25, zwischen der Verbindung 22 und der zweiten Schaltdiode 26, zwischen der ersten Schaltdiode 25 und der ersten Kapazitätsdiode 23 des zweiten frequenzbestimmenden Elements bzw. zwischen der zweiten Schaltdiode 26 und der zweiten Kapazitätsdiode 24 des zweiten frequenzbestimmenden Elements angeschlossen sind, während je ein weiterer Anschluß der Stromquellen 27 bis 30 entweder mit dem Versorgungsspannungsanschluß 8 oder Masse verbunden ist. Somit wird die erste Schaltdiode 25 durch die steuerbaren Stromquellen 27 und 28, die zweite Schaltdiode 26 durch die steuerbaren Stromquellen 29 und 30 gespeist. Durch Umsteuern bzw. Ein- und Ausschalten der steuerbaren Stromquellen 27 bis 30 kann den Schaltdioden 25, 26 entweder ein Gleichstrom aufgeprägt werden, durch den sie in den leitenden Zustand geschaltet werden, oder es können die steuerbaren Stromquellen 27 bis 30 stromlos geschaltet werden, so daß auch die Schaltdioden 25, 26 gesperrt werden. Im ersteren Fall ist das zweite frequenzbestimmende Element 23, 24 parallel zu dem ersten frequenzbestimmenden Element 13 bis 16 geschaltet, im zweiten Fall ist diese Verbindung unterbrochen, und der Oszillator 1 arbeitet auf der ersten Schwingfrequenz.

Parallel zu der Reihenschaltung der Kapazitätsdioden 23, 24 ist eine Reihenschaltung zweier Widerstände 31, 32 angeordnet, deren Verbindungspunkt 33 mit einer ersten Anzapfung 34 eines Widerstands-Spannungsteilers aus zwei Widerständen 35 und 36 verbunden ist, die zwischen einem weiteren Referenzspannungsanschluß 37 und Masse angeordnet sind. Ein weiterer Widerstand 38 ist einerseits mit dem Verbindungspunkt 39 zwischen den Kapazitätsdioden 23 und 24 und andererseits mit einer zweiten Anzapfung 40 des Widerstands-Spannungsteilers 35, 36 verbunden, die durch den Verbindungspunkt der beiden Widerstände 35 und 36 gebildet wird. Über den Widerstands-Spannungsteiler 35, 36 sowie die Widerstände 31, 32, 38 werden einerseits die Kapazitätsdioden 23, 24 in Sperrichtung vorgespannt; andererseits ist die Schaltungsanordnung derart dimensioniert, daß bei abgeschalteten Stromquellen 27 bis 30 die Schaltdioden 25, 26 zuverlässig in den gesperrten Zustand überführt sind.

In vorteilhafter Weise sind die steuerbaren Stromquellen 27 bis 30 in einer gemeinsamen Stromspiegelanordnung miteinander verbunden. Dazu enthält jede der steuerbaren Stromquellen 27 bis 30 wenigstens einen Stromquellentransistor, und die Steueranschlüsse dieser Stromquellentransistoren sind gemäß den in der Figur durch gestrichelte Linien wiedergegebenen Wirkverbindungen 41 bzw. 42 paarweise miteinander verknüpft. Insbesondere werden die mit dem Versorgungsspannungsanschluß 8 verbundenen Stromquellen 27, 29 einerseits und die mit Masse verbundenen Stromquellen 28, 30 andererseits jeweils gemeinsam durch die Wirkverbindung 41 bzw. 42 gesteuert, vorzugsweise durch unmittelbare Verbindung der Steueranschlüsse der in ihnen vorhandenen Stromquellentransistoren. Eine Stromsteuerschaltung 43 umfaßt dabei vorzugsweise einen Stromspiegel, durch den die Wirkverbindungen 41 und 42 gemeinsam gesteuert werden. Der Eingangs- bzw. Primärzweig dieses Stromspiegels in der Stromsteuerschaltung 43 ist über einen Schalttransistor abschalt- bzw. überbrückbar und damit wahlweise in einen stromlosen Zustand überführbar, wodurch dann über die Wirkverbindungen 41, 42 auch die steuerbaren Stromquellen 27 bis 30 stromlos geschaltet werden. Dieser Schalttransistor ist symbolisch innerhalb des die Stromsteuerschaltung 43 repräsentierenden Schaltungsblocks dargestellt.

Die Stromsteuerschaltung 43 wird durch eine erste Treiberstufe 44 gesteuert, von der im wesentlichen der Schalttransistor innerhalb der Stromsteuerschaltung 43 betätigt wird. Die erste Treiberstufe 44 umfaßt insbesondere einen Differenzverstärker, dessen erster Eingang 45 mit einem Steuersignalanschluß 46 und dessen zweiter Eingang 47 mit einer ersten Anzapfung 48 eines zwischen den Versorgungsspannungsanschluß 8 und Masse geschalteten, zweiten Widerstandsteilers aus drei Widerständen 49, 50, 51 verbunden ist. Durch den zweiten Widerstands-Spannungsteiler 49, 50, 51 wird an dessen erster Anzapfung 48 ein Schwellenwert bereitgestellt, bei dessen Über- bzw. Unterschreiten durch das Steuersignal am Steuersignalanschluß 46 das Umsteuern der steuerbaren Stromquellen 27 bis 30 und damit das Zu- bzw. Abschalten des zweiten frequenzbestimmenden Elements 23, 24 vorgenommen wird. In der Figur erfolgt die Bereitstellung des Steuersignals am Steuersignalanschluß 46 über einen weiteren Spannungsteiler aus einem vom Steuersignalanschluß 46 an den Versorgungsspannungsanschluß 8 gelegten Widerstand 52 und einem vom Steuersignalanschluß 46 an Masse gelegten, veränderbaren Widerstand 53. Dabei kann vorzugsweise die Verbindung zwischen dem Widerstand 53 und Masse durch eine Schaltvorrichtung 59 unterbrechbar sein. Insbesondere kann die gesamte, bisher beschriebene Schaltungsanordnung auf einem Halbleiterkörper zusammengefaßt sein, und der Steuersignalanschluß 46 kann bevorzugt ein externer Anschluß der so gebildeten, integrierten Schaltungsanordnung sein. Der veränderbare Widerstand 53 kann dann beispielsweise durch einen Steuertransistor oder ein Potentiometer gebildet werden.

Bei der erfindungsgemäßen Schaltungsanordnung wird jedoch vorteilhaft über den Steuersignalanschluß 46 mit der Zu- bzw. Abschaltung des zweiten frequenzbestimmenden Elements auch dessen Abstimmung auf die gewünschte, zweite Schwingfrequenz des Oszillators 1 vorgenommen. Dazu ist eine zweite Treiberstufe 54 vorgesehen, deren erster Eingang 55 ebenfalls mit dem Steuersignalanschluß 46 und dessen zweiter Eingang 56 mit einer zweiten Anzapfung 57 des zweiten Widerstands-Spannungsteilers 49 bis 51 verbunden ist. Diese zweite Treiberstufe 54 ist mit ihrem Ausgang 58 mit der zweiten Anzapfung 40 des Widerstands-Spannungsteilers 35, 36 verbunden.

Der durch die Spannung an der zweiten Anzapfung 57 gegebene Schwellenwert für die zweite Treiberstufe 54 ist gegenüber dem von der ersten Anzapfung 48 abgegriffenen Schwellenwert für die erste Treiberstufe 44 derart bemessen, daß der Schwellenwert an der ersten Treiberstufe 44 einen Aussteuerungsbereich der zweiten Treiberstufe 54 begrenzt, der durch den Schwellenwert an dieser zweiten Treiberstufe 54 festgelegt ist. Vorzugsweise umfaßt auch die zweite Treiberstufe 54 einen Differenzverstärker, und der Aussteuerungsbereich der Spannung zwischen den Eingängen 55 und 56, innerhalb dessen diese in linearem Zusammenhang mit einem dadurch ausgelösten Signal am Ausgang 58 steht, ist durch Wahl des Schwellenwertes an der zweiten Anzapfung 57 auf einen derartigen Pegel gebracht, daß bei Erreichen eines (vorzugsweise des oberen) Randes dieses Aussteuerungsbereiches das Steuersignal am Steuersignalanschluß 46 den Schwellenwert am ersten Eingang 45 der ersten Treiberstufe 44 erreicht und damit das zweite frequenzbestimmende Element 23, 24 abgeschaltet wird. Im genannten Aussteuerungsbereich wird dann von der zweiten Treiberstufe 54 der Vorspannung des zweiten frequenzbestimmenden Elements 22, 24 an der zweiten Anzapfung 40 eine Stellspannung zum Verändern der Kapazitätswerte der Kapazitätsdioden 23, 24 überlagert.

Im Ausführungsbeispiel nach der Figur wurden der Einfachheit halber der zweite Widerstandsspannungsteiler 49 bis 51, der weitere Spannungsteiler 52, 53, die Kollektorwiderstände 5, 6, die Stromquellen 27 und 29 sowie die Kollektoranschlüsse der Emitterfolgertransistoren 9, 10 an denselben Versorgungsspannungsanschluß 8 gelegt. Je nach den erforderlichen Potentialen können hierfür auch unterschiedliche Versorgungsspannungsanschlüsse vorgesehen sein.

In einem Dimensionierungsbeispiel des erfindungsgemäßen Oszillators zum Umschalten zwischen den französischen Videosignal-Übertragungsnormen L und L' beträgt die erste Schwingfrequenz das Doppelte der Bildträgerfrequenz von 38,9 MHz für die Übertragungsnorm L und die zweite Schwingfrequenz das Doppelte der Bildträgerfrequenz von 33,9 MHz für die Übertragungsnorm L'. Das zweite frequenzbestimmende Element 23, 24 wird beim Einstellen des Oszillators auf die Übertragungsnorm L' durch Schließen der Schaltvorrichtung 59 zugeschaltet. Über den veränderbaren Widerstand 53, die zweite Treiberstufe 54 und die Variation der Kapazitätswerte der Kapazitätsdioden 23, 24 läßt sich für den Oszillator 1 mit zugeschaltetem zweitem frequenzbestimmendem Element ein Stellumfang von etwa 1,2 MHz erreichen. Der erfindungsgemäße Oszillator weist außerdem eine niedrige Variation der Schwingfrequenz über der Betriebstemperatur auf.

Beim Abgleich eines Oszillators, wie er im vorstehenden beschrieben ist, über den Referenzspannungsanschluß 18 zeigt sich, daß die Steilheit der Abgleichkennlinie, d.h. die Abhängigkeit der Änderung der Schwingfrequenz von der Änderung der Sperrvorspannung am Referenzspannungsanschluß 18 beim Einstellen auf die unterschiedlichen Schwingfrequenzen verändert wird. Diese Veränderung der Steilheit beruht auf den unterschiedlichen Werten der frequenzbestimmenden Elemente, vorzugsweise der Kapazitätsdioden, für die unterschiedlichen Schwingfrequenzen. Insbesondere bei einem Einsatz des beschriebenen Oszillators in einer phasenverriegelten Regelschleife wirken sich die unterschiedlichen Steilheiten in einer Veränderung des Regelverhaltens der Regelschleife zwischen den unterschiedlichen Schwingfrequenzen aus.

Dieser Erscheinung kann durch ein Verstärkungselement 60 begegnet werden, dessen Verstärkungsfaktor gemeinsam mit dem Zuschalten wenigstens eines der zweiten frequenzbestimmenden Elemente 23, 24 umschaltbar ist. Über dieses Verstärkungselement 60 wird dem Referenzspannungsanschluß 18 ein Abgleichsignal zugeführt, aus welchem sich mit dem genannten Verstärkungsfaktor die Sperrvorspannung am Referenzspannungsanschluß 18 ergibt. Der Verstärkungsfaktor des Verstärkungselementes 60 ist vorzugsweise zu jeder der Schwingfrequenzen derart gewählt, daß sich für den Abgleich des Oszillators 1 durch das Abgleichsignal auf alle einstellbaren Schwingfrequenzen Abgleichkennlinien mit wenigstens nahezu übereinstimmender Steilheit ergeben. Somit werden die durch die unterschiedlichen Steilheiten abweichenden "Übersetzungsverhältnisse" zwischen einem zugeführten Abgleichsignal und einer Änderung der Schwingfrequenz durch die unterschiedlichen Verstärkungsfaktoren korrigiert, so daß insgesamt stets wenigstens nahezu gleiche Kennlinie zwischen dem Abgleichsignal einerseits und den Änderungen der Schwingfrequenzen andererseits vorliegen. Eine mit dem Oszillator 1 aufgebaute, phasenverriegelte Regelschleife hat dann bei allen einstellbaren Schwingfrequenzen identisches Regelverhalten.

Im Ausführungsbeispiel nach der Figur ist das Verstärkungselement 60 mit seinem Ausgang 61 mit dem Referenzspannungsanschluß 18 verbunden. Einem Eingang 62 des Verstärkungselements 60 wird das Abgleichsignal zugeführt. Der Eingang 62 ist außerdem mit einem Anschluß 63 verbunden, über den dieses Abgleichsignal als AFC-Spannung anderen Signalverarbeitungsstufen zugeführt werden kann. Der Verstärkungsfaktor des Verstärkungselements 60 wird über einen Umschalteingang 64 auf den jeweils gewünschten Wert eingestellt. Der Umschalteingang 64 ist dazu mit einem Ausgang 65 der stromsteuerschaltung 43 verbunden, der eine den Wirkverbindungen 41, 42 entsprechende Funktion aufweist. Damit werden die steuerbaren Stromquellen 27 bis 30 und das Verstärkungselement 60 von der Stromsteuerschaltung 43 simultan gesteuert bzw. umgeschaltet.

In einer Abwandlung dieser Ausgestaltung kann das Verstärkungselement 60 mit seinem Eingang 62 mit dem Referenzspannungsanschluß 18 und mit seinem Ausgang 61 mit dem Anschluß 63 verbunden sein. Das Abgleichsignal wird dann unmittelbar vom Referenzspannungsanschluß 18 als Sperrvorspannung auf die Kapazitätsdioden 15, 16 gegeben und andererseits dem Eingang 62 des Verstärkungselements 60 zugeführt. Nach einer durch den umschaltbaren Verstärkungsfaktor vorgegebenen Verstärkung, die wiederum die unterschiedlichen Steilheiten der Kennlinien zwischen der Sperrvorspannung und der Schwingfrequenz ausgleicht, gelangt das Abgleichsignal als AFC-Signal an den Anschluß 63.

## Patentansprüche

1. Oszillator mit für eine erste Schwingfrequenz vorgesehenen ersten frequenzbestimmenden Elementen und wenigstens einem zweiten frequenzbestimmenden Element, welches zum Einstellen des Oszillators auf eine zweite Schwingfrequenz den ersten frequenzbestimmenden Elementen zuschaltbar ist, gekennzeichnet durch ein Verstärkungselement, dessen Verstärkungsfaktor gemeinsam mit dem Zuschalten wenigstens eines der zweiten frequenzbestimmenden Elemente umschaltbar ist, und über das den ersten frequenzbestimmenden Elementen ein Abgleichsignal zuführbar ist.

2. Oszillator nach Anspruch 1,
dadurch gekennzeichnet, daß das erste frequenzbestimmende Element eine erste Kapazität umfaßt, der eine zweite Kapazität als das zweite frequenzbestimmende Element parallel schaltbar ist.

3. Oszillator nach Anspruch 1 oder 2,
dadurch gekennzeichnet, daß das zweite frequenzbestimmende Element über wenigstens eine Schaltdiode zuschaltbar ist.

4. Oszillator nach Anspruch 3,
gekennzeichnet durch eine Speiseschaltung, die wenigstens eine steuerbare Stromquelle umfaßt, durch die die Schaltdiode gespeist wird und wahlweise in den leitenden oder gesperrten Zustand schaltbar ist.

5. Oszillator nach Anspruch 4,
dadurch gekennzeichnet, daß die Speiseschaltung eine (erste) Treiberstufe zum Steuern der steuerbaren Stromquelle(n) umfaßt.

6. Oszillator nach Anspruch 4 oder 5,
dadurch gekennzeichnet, daß die Speiseschaltung eine Einrichtung zum Abstimmen des zweiten frequenzbestimmenden Elements umfaßt.

7. Oszillator nach Anspruch 6,
dadurch gekennzeichnet, daß das zweite frequenzbestimmende Element wenigstens eine Kapazitätsdiode aufweist und die Einrichtung zum Abstimmen des zweiten frequenzbestimmenden Elements eine zweite Treiberstufe zum Erzeugen einer Einstellspannung für diese Kapazitätsdiode umfaßt.

8. Oszillator nach Anspruch 7 in Verbindung mit Anspruch 5,
dadurch gekennzeichnet, daß die Treiberstufen je einen Differenzverstärker umfassen, daß die Differenzverstärker an je einem ihrer Eingänge mit einem gemeinsamen Steuersignal gesteuert werden und daß ihren zweiten Eingängen Schwellenwerte unterschiedlicher Höhe zugeführt werden, die derart bemessen sind, daß der der ersten Treiberstufe zugeführte Schwellenwert einen durch den der zweiten Treiberstufe zugeführten Schwellenwert festgelegten Aussteuerungsbereich der zweiten Treiberstufe begrenzt.

9. Oszillator nach Anspruch 1,
dadurch gekennzeichnet, daß der Verstärkungsfaktor zu jeder der Schwingfrequenzen derart gewählt ist, daß sich für den Abgleich des Oszillators durch das Abgleichsignal auf alle einstellbaren Schwingfrequenzen Abgleichkennlinien mit wenigstens nahezu übereinstimmender Steilheit ergeben.

## Claims

1. An oscillator having first frequency-determining elements provided for a first oscillation frequency and at least a second frequency-determining element which can be connected to the first frequency-determining elements for adjusting the oscillator to a second oscillation frequency, characterized by an amplifier element whose gain factor, jointly with the connection of at least one of the second frequency-determining elements, is switchable and via which an adjusting signal can be applied to the first frequency-determining elements.

2. An oscillator as claimed in claim 1, characterized in that the first frequency-determining element comprises a first capacitance which can be connected in parallel with a second capacitance as the second frequency-determining element.

3. An oscillator as claimed in claim 1 or 2, characterized in that the second frequency-determining element can be connected via at least a switching diode.

4. An oscillator as claimed in claim 3, characterized by a supply circuit which comprises at least a controllable current source by which the switching diode is fed and which is optionally switchable between the conducting or the blocked state.

5. An oscillator as claimed in claim 4, characterized in that the supply circuit comprises a (first) driver stage for controlling the controllable current source(s).

6. An oscillator as claimed in claim 4 or 5, characterized in that the supply circuit comprises a device for tuning the second frequency-determining element.

7. An oscillator as claimed in claim 6, characterized in that the second frequency-determining element comprises at least a capacitance diode and the device for tuning the second frequency-determining element comprises a second driver stage for generating a bias voltage for this capacitance diode.

8. An oscillator as claimed in claim 7, where appendant to claim 5, characterized in that the driver stages comprise a differential amplifier each, in that the differential amplifiers are controlled by a common control signal at one of their inputs and in that their second inputs receive threshold values of different levels which are dimensioned in such a way that the threshold value applied to the first driver stage limits a control range of the second driver stage fixed by the threshold value applied to the second driver stage.

9. An oscillator as claimed in claim 1, characterized in that the gain factor for each of the oscillation frequencies is chosen to be such that adjusting characteristics having at least substantially corresponding slopes result for the adjustment of the oscillator to all adjustable oscillation frequencies by the adjusting signal.

## Revendications

1. Oscillateur avec des premiers éléments déterminant la fréquence prévus pour une première fréquence d'oscillations et au moins un deuxième élément déterminant la fréquence qui peut être commuté en vue du réglage de l'oscillateur sur une deuxième fréquence d'oscillations sur les premiers éléments déterminant la fréquence, caractérisé par un élément d' amplification dont le facteur d' amplification peut être commuté en même temps que la commutation d'au moins un des deux éléments déterminant la fréquence et par l'intermédiaire duquel un signal d'égalisation peut être amené aux premiers éléments déterminant la fréquence.

2. Oscillateur selon la revendication 1, caractérisé en ce que le premier élément déterminant la fréquence comprend une première capacité qui peut être montée en parallèle à une deuxième capacité comme deuxième élément déterminant la fréquence.

3. Oscillateur selon une des revendications 1 ou 2, caractérisé en ce que le deuxième élément déterminant la fréquence peut être commuté par l'intermédiaire d'au moins une diode de commutation.

4. Oscillateur selon la revendication 3, caractérisé par un circuit d'alimentation qui comprend au moins une source de courant commandable par laquelle la diode de commutation est alimentée et peut être commutée au choix à l'état conducteur ou à l'état bloqué.

5. Oscillateur selon la revendication 4, caractérisé en ce que le circuit d'alimentation comprend un (premier) étage excitateur en vue de la commande de la ou des sources de courant commandables.

6. Oscillateur selon l'une des revendications 4 ou 5, caractérisé que le circuit d'alimentation comprend un dispositif de syntonisation du deuxième élément déterminant la fréquence.

7. Oscillateur selon la revendication 6, caractérisé en ce que le deuxième élément déterminant la fréquence présente au moins une diode de capacité et le dispositif de syntonisation du deuxième élément déterminant la fréquence comprend un deuxième étage excitateur en vue de la production d'une tension de réglage pour cette diode de capacité.

8. Oscillateur selon la revendication 7 combinée à la revendication 5, caractérisé en ce que les étages excitateurs comprennent respectivement un amplificateur différenciateur de telle sorte que l'amplificateur différenciateur soit commandé à chacune de ses entrées respectives par un signal de commande commun et que des valeurs seuils de différents niveaux soient amenées à ses deuxièmes entrées et soient dimensionnées de telle sorte que la valeur seuil amenée au premier étage excitateur limite une gamme dynamique du deuxième étage excitateur définie par la valeur seuil amenée au deuxième étage excitateur.

9. Oscillateur selon la revendication 1, caractérisé en ce que le facteur d'amplification est choisi pour chacune des fréquences d'oscillations de telle sorte que, pour l'égalisation de l'oscillateur par le signal d'égalisation sur toutes les fréquences d'oscillations réglables, des caractéristiques d'égalisation avec une pente correspondante, du moins pratiquement, soient obtenues.
